Europäisches Patentamt

European Patent Office

Office européen des brevets

(11) Veröffentlichungsnummer: **0 256 226**
**B1**

(12) **EUROPÄISCHE PATENTSCHRIFT**

(45) Veröffentlichungstag der Patentschrift:
12.09.90

(51) Int. Cl.⁵: **C23C 14/16, F16C 33/12**

(21) Anmeldenummer: 87107341.7

(22) Anmeldetag: 20.05.87

(54) Verbundwerkstoff mit mindenstens einer durch Kathodenzerstäubung (Sputtering) aufgebrachten Gleitsischt, Verfahren zu seiner Herstellung und Verwendung desselben.

(30) Priorität: 15.07.86 CH 2806/86

(43) Veröffentlichungstag der Anmeldung:
24.02.88 Patentblatt 88/8

(45) Bekanntmachung des Hinweises auf die Patenterteilung:
12.09.90 Patentblatt 90/37

(84) Benannte Vertragsstaaten:
AT DE ES FR GB IT SE

(56) Entgegenhaltungen:
DE-A- 2 935 417
FR-A- 2 443 926
FR-A- 2 559 507

Fachkunde Kraftfahrzeugtechnik, 18. Aufl., Seite 132,
Verlag Europa-Lehrmittel, Wuppertal

(73) Patentinhaber: BALZERS AKTIENGESELLSCHAFT,
FL-9496 Balzers(LI)

(72) Erfinder: Bergmann, Erich, Dr., sarganserstrasse 58,
CH-8887 M██(CH)
Erfinder: Pfestorf, Harald, Dipl.-Ing.,
Panoramastrasse 18/1, D-7101 Untereisesheim(DE)
Erfinder: Braus, Jürgen Dipl.-Ing., Johann Jakob
Astor-Strasse 53, D-6909 Walldorf(DE)

(74) Vertreter: Troesch, Jacques J., Dipl.-Ing. et al, Dr.
Troesch AG Patentanwaltsbüro
Walchestrasse 19/Postfach, CH-8035 Zürich(CH)

## Beschreibung

Die Erfindung bezieht sich auf einen Verbundwerkstoff bestehend aus einem Substrat eines Grundwerkstoffes und mindestens einer durch Kathodenzerstäubung (Sputtering) aufgebrachten Gleitschicht, die aus einem Gemisch von in statistischer Verteilung aufgestäubten Teilchen aus mindestens einem eine fest zusammengefügte Matrix bildenden metallischen Werkstoff und mindestens einem weiteren metallischen Werkstoff besteht, der in festem Zustand praktisch nicht im Werkstoff der Matrix löslich ist. Sie bezieht sich ferner auf ein Verfahren zum Herstellen deratiger Verbundwerkstoffe sowie auf eine Verwendung derselben.

Gleitschichten als Oberflächenschichten von Verbundwerkstoffen finden beispielsweise Anwendung für Lagerschalen von Verbrennungsmotoren und müssen neben anderen folgende Eigenschaften aufweisen: geringere Härte als das Material der Welle, hohe Festigkeit gegenüber dynamischer Wechselbeanspruchung, hohen Scherwiderstand, Wärmestabilität der mechanischen Eigenschaften sowie hohe Korrosionsfestigkeit. Diese Anforderungen erfüllen Mischungen aus Blei oder Zinn mit Metallen, die der Schicht durch bildung einer zusammenhängenden Matrix mechanische Festigkeit verleihen, selbst korrosionsfest sind und keine Löslichkeit für Zinn oder Blei aufweisen, wie beispielsweise Aluminium, Chrom oder Nickel. Verbundwerkstoffe mit blei- oder zinnhaltigen Gleitschichten sowie Verfahren zu deren herstellung mittels Kathodenzerstäubung (Sputtering) sind in den DE-PS 28 53 724 und 29 14 618 sowie in der DE-OS 34 04 880 beschrieben. Bei der Anwendung dieser Verfahren haben sich indessen erhebliche Schwierigkeiten hindsichtlich der Erzielung hoher Haftfestigkeit und Bindungsfestigkeit zwischen Unterlage und aufgebrachter Gleitschicht ergeben. Diese Verfahren führen darüberhinaus zu einer verhältnismässig groben Struktur der Gleitschicht, in welche Zinn- oder Bleibatzen von mehreren µm Durchmesser in Zufallsverteilung eingelagert sind. Eine derartige Schichtstruktur führt zu einer entsprechenden Beeinträchtigung der Korrosionseigenschaften.

Zwar ist im Stand der Technik weiter hervorgehoben worden, dass eine durch Kathodenzerstäubung aufgebrachte Gleitschicht auf der Basis einer Legierungszusammensetzung von AlSn20 in einer konventionellen Stahl-CuPb-Dreischichtanordnung zumindest eine feinere Verteilung der Sn-haltigen Partikel aufweise als die nach den herkömmlichen Methoden aufgewalzten Schichten. Dennoch musste eingeräumt werden, dass auch derartige Schichten zu schlecht definierten, heterogenen Mischungen von Aluminium und Zinn führten. Präzise Angaben über die mittlere Partikelgrösse in derartigen Gleitschichten und über reproduzierbare Reaktionsbedingungen zu deren Herstellung sind bis heute nicht bekanntgeworden (vgl. U. ENGEL, Development and Testing of New Multi-Layer Materials for Modern Engine Bearings: part 2 - Copper-Lead-Three-layer Bearings with Sputtered overlay, in SAE Technical Paper Series, Int. Congress and Exposition, Detroit, February 24-28, 1986, Seiten 76 und 77).

Auch die im Stand der Technik vorgeschlagene Verfestigung der Matrix durch gezielte Einlagerung von Oxiden (Dispersionsverfestigung) hat in der Praxis zu erheblichen Schwierigkeiten geführt: So wurden zwar für eine Marix aus Aluminium Konzentrationen der Oxidteilchen zwischen 0.1 und 0.5 Gewichtsprozenten vorgeschrieben (DE-PS 29 14 618, Spalte 5). Eine derartige Konzentration ist indessen bei der Fertigung grosser Serien, beispielsweise von Gleitlagern, nur mit grössten Schwierigkeiten oder überhaupt nicht zu kontrollieren. Dies wiederum führt im Ergebnis zu stark variierenden Schichteigenschaften und einer insgesamt unbefriedigenden Reproduzierbarkeit des Verfahrens zur Erzeugung der betreffenden Schichten.

Der Erfindung liegt dementsprechend die **Aufgabe** zugrund, einen Verbundwerkstoff der im Gattungsbegriff umschriebenen Art dahingehend zu verbessern, dass seine Haftfestigkeit und Korrosionsfestigkeit wesentlich erhöht und die fehlende Reproduzierbarkeit der Verfahren zu seiner Herstellung beseitigt wird.

Die Aufgabe wird erfindungsgemäss durch die folgenden Merkmale gelöst: (a) der in der Matrix unlösliche Werkstoff weist einen niedrigeren Schmelzpunkt auf als der Matrixwerkstoff, und (b) der Durchmesser der Partikel aus dem in der Matrix unlöslichen Werstoff weist eine statistische Normalverteilung mit einem Mittelwert von $\bar{x} < 0.8$ µm auf.

Diese Aufgabe kann somit nicht einfach durch eine im Kathodenzerstäubungsverfahren gebildete Gleitschicht gelöst werden, sondern dadurch, dass dieser erfindungsgemässen Gleitschicht in gezielter Weise spezifische Eigenschaften verliehen werden. Wie sich dabei überraschenderweise herausgestellt hat, erhalten die erfindungsgemässen Gleitschichten im Gegensatz zu den im Stand der Technik offenbarten Schichten durch eine rund zehnmal feinere Verteilung der den unlöslichen Werkstoff enthaltenden Partikel ohne Beteilung von Oxidteilchen die für Gleitlager notwendigen mechanischen Eigenschaften. Weist beispielsweise stranggegossenes AlSn20Cu eine Vickershärte von 35 und nach einer Dispersionsverfestigung mit Oxidteilchen eine solche von 130 auf (DE-PS 28 53 724 Spalte 6), so erreichen die erfindungsgemässen Schichten ohne Beteiligung von Oxiden eine Härte von mindestens 180 Vickers ($HV_{0.1}$). Diese kann durch einen gezielten Zusatz von maximal 0.2 Gewichtsprozenten Oxiden auf gegen 200 gesteigert werden. Daneben zeigen die erfindungsgemässen Schichten gegenüber den im Stand der Technik offenbarten eine wesentlich gesteigerte Anlassbeständigkeit. Während eine 300-stündige Wärmebehandlung bei 170° C bei konventionellen Gleitschichten zu einem erheblichen Härteabfall führt (vgl. DE-PS 28 53 724), sinkt die Härte der erfindungsgemässen Schich ten auch nach einer derartigen Wärmebehandlung nicht unter 170 Vickers.

Die erfindungsgemässen Schichten weisen darüberhinaus eine wesentlich höhere Korrosionsfestigkeit als die durch Oxide dispersionsverfestigten Schichten auf, was auf die geringere Porengrösse zwischen Matrix und unlöslichen Partikeln zurückzuführen ist. Durch die erreichte feine und gleichmässige Verteilung der in der Matrix unlöslichen Partikel in der Gleitschicht wird es zudem möglich, beinahe beliebige Prozentsätze dieses unlöslichen Werkstoffes in die Schicht einzubauen, ohne dass die Gefahr entsteht, dass die Partikel durch mechanische Belastung, namentlich durch dynamische Wechselbelastung, aus dem Matrixmaterial herausgerissen werden oder dass dabei Risse infloge innerer Kerbwirkung in der Gleitschicht auftreten. Auf diesen Zusammenhängen beruht die gegenüber konventionellen Gleitschichten wesentlich gesteigerte Festigkeit der erfindungsgemässen Gleitschichten gegenüber dynamischer Wechselbeanspruchung sowie die gesteigerte Wärmestabilität der mechanischen Eigenschaften dieser Schichten.

Im einzelnen kann die Erfindung derart ausgestaltet werden, dass als in der Matrix unlösliche Komponente mindestens eines der verhältnismässig niedrig schmelzenden Elemente Zinn (Smp 231.89° C), Blei (Smp 327.4° C) oder Indium (Smp 156.4° C) eingesetzt wird. Für Sonderanwendungen sind aber auch weitere niedrigschmelzende Metalle und ihre Legierungen nicht ausgeschlossen (Cadmium, Smp 320.9° C, Wismut, Smp 271.3° C, Thallium Smp. 302° C, Zink Smp 419.5° und Gallium, Smp. 29.8° C). die Erfindung weist besondere Vorteile für Verbundwerkstoffe oder -werkstücke auf, bei denen der matrixbildende Werkstoff eine herkömmliche Gleitlagerlegierung enthält, deren Hauptbestandteil mindestens eines der folgenden Elemente ist: Aluminium, Chrom, Nickel, Magnesium oder Kupfer. In der Praxis hat es sich als besonders vorteilhaft erwiesen, wenn die Gleitschicht insgesamt eine Zusammensetzung mit einer der folgenden Kombinationen aufweist: AlCuSn, AlCuPb, AlCuSnPb, AlSiSn, AlSiPb, AlSiSnPb, CuSn, CuPb, CuSnPb. Erfindungsgemässe Gleitschichten weisen vorzugsweise Schichtdicken zwischen 10 und 30 µm auf, wobei die untere Hälfte dieses Bereichs (12 bis 16 µm) für die meisten Anwendungsprobleme ausreicht. Die im Stand der Technik vorgeschlagene optimale Schichtdicke konventioneller Zweikomponentengleitschichten von 18 µm konnte insofern nicht betätigt werden (vgl. ENGEL, a.a.O. S.76).

In Ausgestaltung der Erfindung weist der Durchmesser der Partikel aus dem in der Matrix unlöslichen Werkstoff eine statistische Normalverteilung vorzugsweise mit einem Mittelwert $\bar{x}$ von 0.05 bis 0.4 µm auf, wobei die Experimente ergeben haben, dass mit einem erfindungsgemässen Effekt noch bis etwa zu einem Wert von $\bar{x} < 0.8$ µm gerechnet werden kann.

Aus dem Stand der Tecknik (DE-P 29 14 618, Spalte 5, DE-PS 28 53 724, Spalte 5) ist bekannt, das Oxidgehalte zwischen 0.1 und 0.5 % (Volumen) zu einer sogenannten Dispersionsverfestigung führen. Demgegenüber hat sich überraschenderweise gezeigt, dass erfindungsgemässe Schichten, bei deren Herstellung durch geeignete massnahmen (Verwendung von in Inertgasatmosphäre hergestellter Targets) der $O_2$-Gehalt auf weniger als 0.2 Gewichts-% reduziert wurde, nicht nur gleiche, sondern wesentlich verbesserte mechanische Eigenschaften gegenüber derartigen dispersionsverstigten Gleitschichten aufweisen.Die Verfestigung durch dispergierte Oxidteilchen kann also durch eine Verfestigung durch Reduktion des Durchmessers der implantierten Partikel substituiert werden.

Die erfindungsgemässen Gleitschichten eignen sich besonders als Oberflächeschicht von Dreischichtengleitlagern, bei denen zwischen dem Grundwerkstoff (Lagerrücken) und der Gleitschicht eine Trägerschicht aus einem Werkstoff mit guten Notlaufeigenschaften unterlegt wird. Für diese unterlegte Schicht kommen verschiedenste Stoffzusammensetzungen in Betracht, wobei lediglich darauf zu achten ist, dass ihre Härte geringer ist als diejenige der Gleitschicht. Im einzelnen können diese Schichten Elemente wie Zinn, Blei, Antimon, Kupfer oder bekannte Legierungen, beispielsweise Zinnbronzen, Zinnbleibronzen (vgl, DIN 1705, 1716, 1718 und 17 662) oder Weissmetalle (vgl. DIN 1703) enthlaten (vgl. M.J.NEALE(Hg.), Tribology Handbook, London 1975, Tabelle C-1). Die Brinellhärte dieser unterlegten Trägerschicht sollte dabei zwischen 30 und 100 kp/m² liegen.

Als vorteilhaft hat es sich weiter erwiesen, zwischen der Gleitschicht und dem Grundwerkstoff eine ebenfalls durch kathodenzerstäubung aufgebrachte dünne Sperrschicht vorzusehen, welche ein Diffundieren von Material aus der Gleitschicht in den Grundwerkstoff bzw. in die unterlegte Trägerschicht verhindert. Diese Diffusionssperrschicht weist vorteilhafterweise eine Schichtdicke von etwa 2 um auf und kann als Hauptbestandteil irgendeinen der matrixbildenden Werkstoffe der Gleitschicht enthalten. Als besonders geeignet haben sich dabei Zusammensetzungen aus Chrom und Nickel erwiesen. Diese Diffusionssperrschicht wird vorteilhafterwiese zwischen der Gleitschicht und der ihr unterlegten Trägerschicht angebracht. Für Sonderanwendungen ist es jedoch nicht ausgeschlossen, diese Sperrschicht zwischen der unterlegten Trägerschicht und dem Grundwerkstoff (Lagerrücken) anzubringen. Ebenso können für Sonderanwendungen mehrere Gleitschichten übereinander angeordnet werden.

Die Erfindung betrifft im weiteren ein **Verfahren** zum Herstellen der vorgeschlagenen Verbunderwerkstoffe, bei dem die Gleitschicht durch Kathodenzerstäubung (Sputtering) aufgebracht wird. Die Aufgabe bei diesem Teil der Erfindung bestand dabei darin, die fehlende Reproduzierbarkeit der im Stand der Technik offenbarten Herstellungsverfahren zu beseitigen und dadurch zu Erzeugnissen mit konstanten mechanischen und Korrosionseigenschaften zu gelangen. Diese Aufgabe wird nach diesem Teil der Erfindung dadurch gelöst, dass die Temperatur des zu beschichtenden Substrats während der Beschichtung unter 150° C gehalten wird. Wie sich überraschenderweise herausgestellt hat, führt eine derartige Reduktion der Substrattemperatur beim Kathodenzerstäubungsverfahren zu einer unerwartet grossen Verminderung des mittleren Durchmessers der in der Matrix unlöslichen Partikel von mehreren µm auf Werte zwischen 0.05 und

0.8 μm und damit zu den erfindungsgemässen Eigenschaften der aufgebrachten Gleitschicht wie höhere Wechselfestigkeit und Korrosionsbeständigkeit.

Neben dieser Reduktion der Beschichtungstempertur trägt auch eine gegenüber dem Stand der Technik erhöhte Beschichtungsgeschwindigkeit (über 0.2 μm/Minute) zu der erfindungsgemässen Feinverteilung der unlöslichen Komponente bei. Dieser Zusammenhang kann in denjenigen Situationen gezielt ausgenützt werden, in denen keine ausreichenden Mengen Kühlwasser für die Durchführung des Verfahrens zur Verfügung stehen.

In Ausgestaltung dieses Verfahrens ist vorgesehen, dass die verschiedenen Werkstoffe der Gleitschicht, also namentlich das die Matrix bildende und das in der Matrix unlösliche Material, **gleichzeitig** mittels Kathodenzerstäubungsverfahren auf die Unterlage aufgebracht werden, wodurch die erfindungsgemässe Feinverteilung der unlöslichen Komponente zusätzlich verbessert wird. Dies kann vorzugsweise dadurch erreicht werden, dass mehr als die Hälfte der in dem Verfahren eingesetzten Targets sowohl den Hauptbestandteil der Matrix als auch den in der Matrix unlöslichen Werkstoff enthalten. Entsprechend der Zusammensetzung der gewünschten Gleitschicht kann es sich dabei namentlich um Legierungen mit folgender Zusammensetzung handeln: AlCuSn, AlCuPb, AlSiSn, AlSiPb, AlSiSnPb, CuSn, CuPb, CuSnPb. Um den Sauerstoff- bzw. Oxidgehalt der Gleitschicht unter 0.2 Gewichts % zu halten, ist es dabei erforderlich, die fraglichen Targets im Vakuum oder unter Inertgasatmosphäre praktisch frei von Sauerstoff zu vergiessen.

In einer anderen Ausgestaltung des Verfahrens werden die verschiedenen Komponenten der Gleitschicht zeitlich nacheinander auf die Unterlage aufgebracht. Dazu werden vorteilhafterwiese Targets aus den hauptkompnenten der Gleitschicht, also beispielsweise aus Reinaluminium und Reinzinn, eingesetzt und an verschiedenen Positionen der betreffenden Beschichtungsvorrichtung aufgesputtert. Besonders vorteilhaft kann es dabei sein, für die Erzeugung der Diffusionssperrschicht und der Gleitschicht die gleichen Targets einzusetzen und die beiden unterschiedlichen Schichten unmittelbar nacheinander auf den zu beschichtenden Werkstücken zu bilden. In einer weiteren Variante des erfindungsgemässen Verfahrens wird die Temperatur des Substrates in dem Sinne variiert, dass die matrixbildende Komponente bei höherer Temperatur aufgebracht wird als die in der Matrix unlösliche Komponente. Dies kann in einer weiteren Variante derart geschehen, dass die matrixbildende Komponente der Gleitschicht bei höherer Substrattemperatur zeitlich vor der unlöslichen Komponente aufgebracht wird und die Temperatur während des Beschichtungsvorganges abgesenkt wird. Weitere Variationsmöglichkeiten des erfindungsgemässen Verfahrens ergeben sich dadurch, das die Spannung, an die das zu beschichtende Substrat gelegt wird entsprechend den Gegebenheiten des konkreten Anwendungsfalles variiert wird. Dies kann vorteilhafterweise derart geschehen, dass die Komponenten mit den höheren Schmelzpunkten, also etwa die matrixbildende Komponente oder die Hauptkomponente der Diffusionssperrschicht, bei höherer Spannung aufgebracht werden als die in der Matrix unlösliche Komponente mit dem nierigeren Schmelzpunkt.

Die erfindungsgemässen Gleitschichten können in Gleitlagern jeder Art erfolgreich eingesetzt werden. Als besonders zweckmässig hat sich ihre Verwendung in sogenannten Dreistoff- oder Dreischichtlagern bei Lagerbelastungen zwischen 80 N/mm$^2$ und 120 N/mm$^2$ und bei Lagerrückentemperaturen zwischen 150 und 200° C erwiesen. Unter diesen Bedingungen zeigen die erfindungsgemässen Schichten auch im Dauerbelastungsversuch nach 720 Stunden keinen messbaren Verschleiss.

Zwei Ausführungsformen der Erfindung werden im folgenden anhand der Zeichnung näher erläutert. Dabei zeigen

Figur 1 einen Querschnitt durch einen erfindungsgemässen Verbundwerkstoff in starker Vergrösserung,

Figur 2 eine rasterelektronenmikroskopische Aufnahme der Oberfläche einer erfindungsgemässen Gleitschicht (b) neben einer konventionellen Gleitschicht (a).

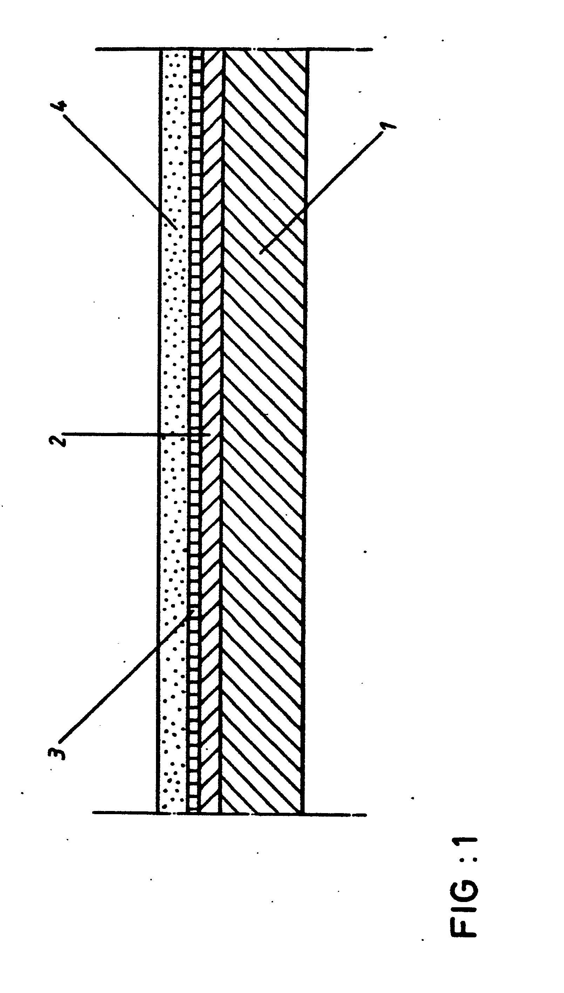

In der Ausführungsform der Figur 1 ist auf einem Stahlrücken (Grundwerkstoff) 1 eine Trägerschicht 2 aus einem Werkstoff mit Notlarfeigenschaften in einer Schichtdicke von 200 bis 700 μm aufgebracht. Wenn für diese Trägerschicht eine Bleioder Bleizinnbronze verwendet wird, so erreicht diese Schicht eine Brinellhärte von 50 bis 100 kp/mm$^2$.

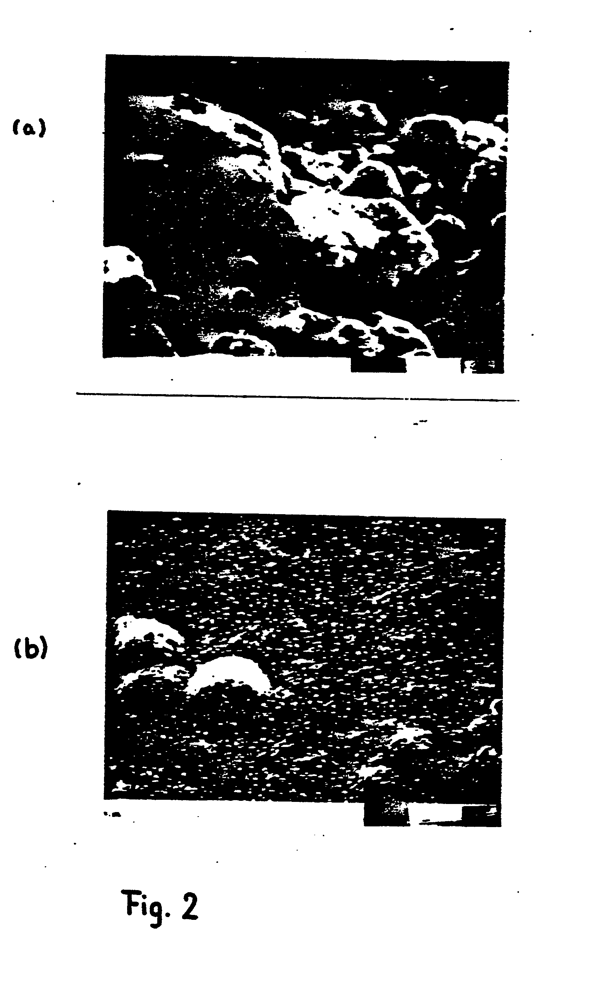

Auf diese Trägerschicht ist im Kathodenzerstäubungsverfahren eine dünne Diffusionssperrschicht 3 mit einer Schichtdicke von üblicherwiese wenigen μm (2 bis 4 μm) aufgebracht. Diese Diffusionssperrschicht 3 besteht vorteilhaftferwiese aus einem oder mehreren Elementen des matrixbildenden Werkstoffes der Gleitschicht, beispielsweise Nickel, Chrom oder eine Legierung dieser beiden. Über dieser Sperrschicht 3 ist die erfindungsgemässe Gleitschicht 4 durch Kathodenzerstäubung aufgebracht. Die im Vergleich zu herkömmlichen Gleitschichten ausserordentlich feine Verteiling der unlöslichen Phase ist aus der rasterelektronenmikroskopischen Aufnahme der Figur 2 ersichtlich, welche eine Gleitschicht mit einem Gewichtsverhältnis von 80:20:1 zwischen den Komponenten der Gleitschicht wiedergibt.

Für die Erzeugung der erfindungsgemässen Verbundwerkstoffe wurde beispielsweise folgende Reaktionsbedingungen eingehalten:

Beispiel 1

Die Beschichtungen wurden in einer an sich bekannten Kathodenzerstäubungsvorrichtung durchgeführt, in welcher ein ringförmiges, dichtes Plasma mittels Magnetfeld unmittelbar vor der Kathode konzentriert wird. Die Anlage wies eine zylindrische Prozesskammer auf, an deren Aussenseite bis zu maximal vier Quellen von je 322.6 cm$^2$ Fläche verti-

kal montiert werden konnten. Die zu beschichtenden Substrate wurden ebenfalls vertikal auf einem Träger angebracht, der durch einen Drehantrieb rotiert werden konnte, der zwischen 0.2 und 24.5 Umdrehungen pro Minute regelbar war (vgl. beispielsweise BALZERS Produktinformationen BB 800 246 PD/ August 1985 sowie BB 800 039 RD/Juli 1985).

Lagerschalen aus unlegiertem Werkzeugstahl (beispielsweise Stoff-Nr. 1.162, Kurzname C80W2) wurden in dieser Zerstäubungsanlage bei einer Substrattemperatur von 60° C, einem Druck von 1.2 Pa in Argon, dem 0.8 Volumenprozente Sauerstoff beigemischt wurde, während 8 Stunden beschichtet. Zur Aufrechterhaltung dieser Substrattemperatur wurden 0.024 m³ Kühlwasser pro Stunde und zu beschichtende Lagerschlale benötigt. Als Targets wurden einerseits Reinaluminium (99.99) bei einer Spannung von 470 Volt, andererseits eine Zinnbronze der Zussamensetzung SnCu5 bei einer Spannung von 620 Volt eingesetzt. Bei einer Rotation der Substrate mit einer konstanten Umdrehungsgeschwindigkeit von 15 Umdrehungden pro Minute wurde dabei eine Beschichtungsgeschwindigkeit von rund 0.3 μm/Min. entsprechend einer Schichtdicke von rund 150 μm am Ende der Behandlung erreicht.

Die auf diese Weise erzeugte Schicht wies ein Bewichtsverhältnis von Al:Sn:Cu von 80:20:1 (entsprechend der Zusammensetzung AlSn20Cul) und einen Oxidgehalt von 0.2 Gewichtsprozenten auf. Ihre Brinellhärte betrug 83 und blieb auch nach einer 200-stündigen Wärmebehandlung bei 170° C unverändert. Beim Test auf der Lagerprüfmaschine während 250 Stunden, einer Belastung von 70 N/mm² und einer Lagerrückentemperatur von T = 160° C ziegten diese Schichten keinen messbaren Verschleiss.

## Beispiel 2

Lagerschalen aus dem gleichen Werkzeugstahl (StoffNr. 1.1625) mit einer im Tauchverfahren aufgebrachten, 200 μm dicken Trägerschicht aus CuPb23Sn4 (Bleibronze) wurden bei einer Substrattemperatur von 30° C und in vollständiger Abwesenheit von Sauerstoff unter ansonsten gleichen Bedingungen wie in Beispiel 1 beschichtet. Die erforderliche Kühlwassermenge betrug dabei 0.035 m³ pro Stunde und zu beschichtende Lagerschale. Zum Aufbringen der Gleitschicht wurden folgende Targets und Leistungsdichten verwendet: 2 Targets AlSi (20 kW/322 cm²), ein Target Zinn (10.3 kW/322 cm²) und ein Target Blei (11 kw/322 cm²). Daraus ergab sich eine Gleitschicht mit der Zusammensetzung AlSi4Sn15Pblo, welche eine Härte von 175 Vickers (HV$_{0.1}$) aufwies.

## Beispiel 3

Lagerschalen mit einer Trägerschicht aus Bleibronze, wie in Beispiel 2 beschreiben, wurden vor dem Aufbringen der Gleitschicht mit einer dünnen Diffusionssperrschicht versehen. Zu diesem Zweck wurden während 12 Minuten und 30° C nur die beiden Targets aus der AlSi-Legierung eingeschaltet (20kW/322 cm²). Die Schichtdicke der so erzeugten Diffusionssperrschicht betrug rund 2 μm. Anschliessend wurden die beiden anderen Targets zugeschaltet und die Beschichtung unter den gleichen Bedingungen wie in Beispiel 2 abgeschlossen.

## Beispiel 4

· Die Prozessbedingungen des Beispiels 3 wurden in dem Sinne variiert, dass zum Aufbringen der Diffusionssperrschicht aus der AlSi-Legierung das Substrat während 12 Minuten nicht gekühlt wurde, wodurch sich eine Substrattemperatur von 200° C einstellte. Anschliessend wurden die beiden anderen Targets zugeschaltet und die Kühlung derart geregelt, dass die Substrattemperatur auf 80° C abfeil. Die Beschichtung wurde im übrigen unter den Bedingungen des Beispiels 2 fortgesetzt.

## Beispiel 5

Die Bedingungen des Beispiels 1 wurden in dem Sinne variiert, dass von einer Substrattemperatur von 20° C ausgegangen wurde unde diese während des Aufbringens der Gleitschicht durch entsprechende Regelung der Kühlleistung kontinuierlich auf 190° C erhöht wurde. Daraus ergab sich eine Gleitschicht mit gegen die Oberfläche zunehmender mittlerer Partikelgrösse der unlöslichen Komponente und dementsprechend kontinuierlich abnehmender Härte.

## Beispiel 6

Die Prozessbedingungen der Beispiele 2 und 3 wurden dahingehend variiert, dass die Diffusionssperrschicht bei 50° C und einer Substratspannung von -200 Volt aufgestäubt wurde, die Gleitschicht dagegen mit Hilfe der vier verschiedenen Targets bei einer Substratspannung von - 40 Volt. Die Zusammensetzung der Gleitschicht entsprach derjenigen des Beispiels 2 (AlSi4Sn15Pblo) mit einer leicht gesteigerten Härte von rund 180 Vickers (HV$_{0.1}$).

## Beispiel 7

Auf eine Diffusionssperrschicht aus NiCu30 mit einer Schichtdicke von 1.5 μm wurde eine Gleitschicht der ungefähren Zusammensetzung AlSn20Cul unter den Bedingungen des Beispiels 1 in völliger Abwesenheit von Sauerstoff aufgebracht. Um die Porosität der Gleitschicht zu vermindern, wurde dabie eine Substrattemperatur von 130° C aufrechterhalten und die Substratspannung während der Behandlungsdauer von insgesamt 50 Minuten kontinuierlich von - 40 Volt auf -180 Volt erhöht. Die derart erzeugten Schichten wiesen gegenüber denjenigen des Beispiels 1 eine erhöhte Korrosionsbeständigkeit auf.

## Patentansprüche

1. Verbundwerkstoff bestehend aus einem Substrat eines Grundwerkstoffes und mindestens einer durch Kathodenzerstäubung (Sputtering) aufgebrachten Gleitschicht, die aus einem Gemisch von in statistischer Verteilung aufgestäubten Teilchen aus mindestens einem eine fest zusammengefügte Matrix bildenden metallischen Werkstoff und mindestens einem weiteren metallischen Werkstoff besteht, der in festem Zustand praktisch nicht im Werkstoff der Matrix löslich ist, dadurch gekennzeichnet, dass

a) der in der Matrix unlösliche Werkstoff einen niedrigeren Schmelzpunkt aufweist als der Matrixwerkstoff, und dass

b) der Durchmesser der Partikel aus dem in der Matrix unlöslichen Werkstoff eine statistische Normalverteilung mit einem Mittelwert von $\bar{x} <$ 0,8 µm aufweist.

2. Verbundwerkstoff nach Anspruch 1, dadurch gekennzeichnet, dass der in der Matrix unlösliche Werkstoff als Hauptbestandteil mindestens eines der folgenden Elemente enthält: Zinn, Blei, Indium, Zink.

3. Verbundwerkstoff nach den Ansprüchen 1 und 2, dadurch gekennzeichnet, dass der matrixbildende Werkstoff eine Legierung enthält, deren Hauptbestandteil mindestens eines der folgenden Elemente ist. Aluminium, Chrom, Nickel, Magnesium, Kupfer.

4. Verbundwerkstoff nach den Ansprüchen 1 bis 3, dadurch gekennzeichnet, dass die Gleitschicht eine Legierung mit einer der folgenden Zusammensetzungen enthält.
AlCuSn, AlCuPb, AlCuSnPb, AlSiSn, AlSiPb, AlSiSnPb, CuSn, CuPb, CuSnPb.

5. Verbundwerkstoff nach den Ansprüchen 1 bis 4, dadurch gekennzeichnet, dass die Gleitschicht eine Schichtdicke zwischen 10 und 3µm aufweist.

6. Verbundwerkstoff nach den Ansprüchen 1 bis 5, dadurch gekennzeichnet, dass die Gleitschicht eine Schichtdicke zwischen 12 und 16µm aufweist.

7. Verbundwerkstoff nach den Ansprüchen 1 bis, dadurch gekennzeichnet, dass der Durchmesser der Partikel aus dem in der Matrix unlöslichen Werkstoff eine statistische Normalverteilung mit einem Mittelwert $\bar{x}$ zwischen 0,05 und 0,4µm aufweist.

8. Verbundwerkstoff nach den Ansprüchen 1 bis 7 dadurch gekennzeichnet, dass der Sauerstoffgehalt der Gleitschicht unter 0,2 Gew.% liegt.

9. Verbundwerkstoff nach den Ansprüchen 1 bis 8, dadurch gekennzeichnet, dass er zwischen dem Grundwerkstoff und der Gleitschicht eine Trägerschicht aus einem Werkstoff mit guten Notlaufeigenschaften aufweist.

10. Verbundwerkstoff nach Anspruch 9 dadurch gekennzeichnet, dass die Trägerschicht eines der folgenden Elemente oder Werkstoffe enthält. Zinn, Blei, Antimon, Kupfer, Zinnbronzen, Zinnbleibronzen, Weissmetalle.

11. Verbundwerkstoff nach den Ansprüchen 9 und 10, dadurch gekennzeichnet, dass er zwischen dem Grundwerkstoff und der Gleitschicht zusätzlich zu der Trägerschicht eine durch Kathodenzerstäubung aufgebrachte Diffusionssperrschicht aufweist.

12. Verbundwerkstoff nach Anspruch 11, dadurch gekennzeichnet, dass die Diffusionssperrschicht mindestens einen der matrixbildenden Werkstoffe nach Anspruch 3 enthält.

13. Verbundwerkstoff nach den Ansprüchen 1 bis 12, dadurch gekennzeichnet, dass er mehrere Gleitschichten aufweist.

14. Verfahren zum Herstellen von Verbundwerkstoff nach den Ansprüchen 1 bis 13, bei dem die Gleitschicht durch Kathodenzerstäubung (Sputtering) auf die Unterlage aufgebracht wird, dadurch gekennzeichnet, dass die Temperatur des Substrats während der Beschichtung unter 150°C liegt.

15. Verfahren nach Anspruch 14, dadurch gekennzeichnet, dass die Beschichtungsgeschwindigkeit mehr als 0,2µm/min beträgt.

16. Verfahren nach den Ansprüchen und 14 und 15 dadurch gekennzeichnet, dass die verschiedenen Werkstoffe der Gleitschicht gleichzeitig aufgebracht werden.

17. Verfahren nach den Ansprüchen 14 bis 16, dadurch gekennzeichnet, dass wenigstens 50% der eingesetzten Targets sowohl den Hauptbestandteil der Matrix als auch den in der Matrix unlöslichen Werkstoff enthalten.

18. Verfahren nach Anspruch 17, dadurch gekennzeichnet, dass wenigstens 50% der eingesetzten Targets eine Legierung mit einer der folgenden Zusammensetzungen enthalte:
AlCuSn, AlCuPb, AlCuSnPb, AlSiSn, AlSiPb, AlSiSnPb, CuSn, CuPb, CuSnPb.

19. Verfahren nach den Ansprüchen 14 und 15, dadurch gekennzeichnet, dass die verschiedenen Bestandteile der Gleitschicht zeitlich nacheinander aufgebracht werden.

21. Verfahren nach Anspruch 19, dadurch gekennzeichnet, dass die Diffusionssperrschicht unter Verwendung der gleichen Targets aufgebracht wird wie die Gleitschicht.

21. Verfahren nach den Ansprüchen 19 und 20, dadurch gekennzeichnet, dass die matrixbildende Komponente bei höherer Substrattemperatur aufgebracht wird als die in der Matrix unlösliche Komponente.

22. Verfahren nach Anspruch 21 dadurch gekennzeichnet, dass die matrixbildende Komponente vor der unlöslichen Komponente aufgebracht wird und die Substrattemperatur während des Beschichtungsvorganges abgesenkt wird.

23. Verfahren nach den Ansprüchen 19 bis 22 dadurch gekennzeichnet, dass die Komponenten mit den höheren Schmelzpunkten bei höheren Substratspannungen aufgebracht werden als die Komponenten mit niedrigerem Schmelzpunkt.

24. Verfahren nach den Ansprüchen 14 bis 23 dadurch gekennzeichnet, dass die Diffusionssperrschicht bei höheren Substrattemperaturen aufgebracht wird als die Bestandteile der Gleitschicht.

25. Verwendung des Verbundwerkstoffes nach den Ansprüchen 1 bis 13 in Gleitlagern.

## Claims

1. A composite material comprising a substrate of a basic material and at least one sliding bearing layer which is applied by cathode sputtering and which comprises a mixture of particles sputtered in a statistical distribution and comprising at least one metal material forming a fixedly assembled matrix, and at least one further metal material which is practically not soluble in the material of the matrix in the solid state, characterised in that
a) the material which is insoluble in the matrix has a lower melting point than the matrix material, and
b) the diameter of the particles of the material which is insoluble in the matrix has a statistical normal distribution with a mean value of $\bar{x} < 0.8$ μm.

2. A composite material according to claim 1 characterised in that the material which is insoluble in the matrix contains as a main component at least one of the following elements: tin, lead, indium and zinc.

3. A composite material according to claims 1 and 2 characterised in that the matrix-forming material contains an alloy whose main component is at least one of the following elements: aluminium, chromium, nickel, magnesium and copper.

4. A composite material according to claims 1 to 3 characterised in that the sliding bearing layer contains an alloy of one of the following compositions:
AlCuSn, AlCuPb, AlCuSnPb,
AlSiSn, AlSiPb, AlSiSnPb,
CuSn, CuPb, CuSnPb.

5. A composite material according to claims 1 to 4 characterised in that the sliding bearing layer is between 10 and 30 μm in thickness.

6. A composite material according to claims 1 to 5 characterised in that the sliding bearing layer is between 12 and 16 μm in thickness.

7. A composite material according to claims 1 to 6 characterised in that the diameter of the particles of the material which is insoluble in the matrix has statistical normal distribution with a mean value $\bar{x}$ of between 0.05 and 0.4 μm.

8. A composite material according to claims 1 to 7 characterised in that the oxygen content of the sliding bearing layer is below 0.2% by weight.

9. A composite material according to claims 1 to 8 characterised in that between the basic material and the sliding bearing layer it has a support layer of a material with good emergency running properties.

10. A composite material according to claim 9 characterised in that the support layer includes one of the following elements or materials: tin, lead, antimony, copper, tin bronzes, tin lead bronzes and white metals.

11. A composite material according to claims 9 and 10 characterised in that between the basic material and the sliding bearing layer, in addition to the support layer, it has a diffusion barrier layer which is applied by cathode sputtering.

12. A composite material according to claim 11 characterised in that the diffusion barrier layer contains at least one of the matrixforming materials according to claim 3.

13. A composite material according to claims 1 to 12 characterised in that it has a plurality of sliding bearing layers.

14. A process for the production of composite material according to claims 1 to 13 wherein the sliding bearing layer is applied to the base support by cathode sputtering characterised in that the temperature of the substrate during the coating operation is below 150°C.

15. A process according to claim 14 characterised in that the coating speed is more than 0.2 μm/min.

16. A process according to claims 14 and 15 characterised in that the various materials of the sliding bearing layer are applied simultaneously.

17. A process according to claims 14 to 16 characterised in that at least 50% of the targets used contain both the main component of the matrix and also the material which is insoluble in the matrix.

18. A process according to claim 17 characterised in that at least 50% of the targets used contain an alloy of one of the following compositions:
AlCuSn, AlCuPb, AlCuSnPb,
AlSiSn, AlSiPb, AlSiSnPb,
CuSn, CuPb, CuSnPb.

19. A process according to claims 14 and 15 characterised in that the various components of the sliding bearing layer are applied successively.

20. A process according to claim 19 characterised in that the diffusion barrier layer is applied using the same targets as the sliding bearing layer.

21. A process according to claims 19 and 20 characterised in that the matrix-forming component is applied at a higher substrate temperature than the component which is insoluble in the matrix.

22. A process according to claim 21 characterised in that the matrix-forming component is applied prior to the insoluble component and the substrate temperature is lowered during the coating operation.

23. A process according to claims 19 to 22 characterised in that the components with the higher melting points are applied at higher levels of substrate voltage than the components with a low melting point.

24. A process according to claims 14 to 23 characterised in that the diffusion barrier layer is applied at higher substrate temperatures than the components of the sliding bearing layer.

25. Use of the composite material according to claims 1 to 13 in friction bearings.

## Revendications

1. Matériau composite se composant d'un substrat en un matériau de base et d'au moins une couche de glissement appliquée par pulvérisation cathodique, qui se compose d'un mélange de particules d'au moins un matériau métallique formant une matrice solidement assemblée et d'au moins un autre matériau métallique, qui, à l'état solide, n'est pratiquement pas soluble dans le matériau de la matrice, reparties en distribution statistique, caractérisé par le fait que:
a) le matériau insoluble dans la matrice présente un point de fusion inférieur à celui du matériau de matrice; et que

b) le diamètre des particules en matériau insoluble dans la matrice présente une distribution statistique normale ayant une valeur moyenne de $\bar{x} < 0,8$ μm.

2. Matériau composite selon la revendication 1, caractérisé par le fait que le matériau insoluble dans la matrice contient comme constituant principal au moins l'un des éléments suivants: étain, plomb, indium, zinc.

3. Matériau composite selon les revendications 1 et 2, caractérisé par le fait que le matériau formant la matrice contient un alliage dont le constituant principal est au moins l'un des éléments suivants: aluminium, chrome, nickel, magnésium, cuivre.

4. Matériau composite selon les revendications 1 à 3, caractérisé par le fait que la couche de glissement contient un alliage ayant l'une des compositions suivantes:

AlCuSn, AlCuPb, AlCuSnPb,

AlSiSn, AlSiPb, AlSiSnPb,

CuSn, CuPb, CuSnPb.

5. Matériau composite selon les revendications 1 à 4, caractérisé par le fait que la couche de glissement présente une épaisseur de couche comprise entre 10 et 30 μm.

6. Matériau composite selon les revendications 1 à 5, caractérisé par le fait que la couche de glissement présente une épaisseur de couche comprise entre 12 et 16 μm.

7. Matériau composite selon les revendications 1 à 6, caractérisé par le fait que le diamètre des particules en matériau insoluble dans la matrice présente une distribution statistique normale ayant une valeur valeur moyenne de $\bar{x}$ comprise entre 0,5 et 0,4 μm.

8. Matériau composite selon les revendications 1 à 7, caractérisé par le fait que la teneur en oxygène de la couche de glissement se situe au-dessous de 0,2% en poids.

9. Matériau composite selon les revendications 1 à 8, caractérisé par le fait qu'entre le matériau de base et la couche de glissement, il comprend une couche support en un matériau ayant de bonnes propriétés de tenue avec lubrification insuffisante.

10. Matériau composite selon la revendication 9, caractérisé par le fait que la couche support contient l'un des éléments ou matériaux suivants: étain, plomb, antimoine, cuivre, bronzes, alliages cuivre-plombétain, métaux blancs.

11. Matériau composite selon les revendications 9 et 10, caractérisé par le fait qu'entre le matériau de base et la couche de glissement, en plus de la couche support, il présente une couche barrière à la diffusion appliquée par pulvérisation cathodique.

12. Matériau composite selon la revendication 11, caractérisé par le fait que la couche barrière à la diffusion contient au moins l'un des matériaux formant la matrice tels que définis à la revendication 3.

13. Matériau composite selon les revendications 1 à 12, caractérisé par le fait qu'il présente plusieurs couches de glissement.

14. Procédé de fabrication d'un matériau composite tel que défini aux revendications 1 à 13, dans lequel la couche de glissement est appliquée sur le substrat par pulvérisation cathodique (sputtering), caractérisé par le fait que la température du substrat pendant l'opération de revêtement se situe au-dessous de 150°C.

15. Procédé selon la revendication 14, caractérisé par le fait que la vitesse de l'opération de revêtement s'élève à plus de 0,2 μm/minute.

16. Procédé selon les revendications 14 et 15, caractérisé par le fait qu'on applique simultanément les différents matériaux de la couche de glissement.

17. Procédé selon les revendications 14 à 16, caractérisé par le fait qu'au moins 50% de la cible employée contiennent non seulement le constituant principal de la matrice, mais encore le matériau insoluble dans la matrice.

18. Procédé selon la revendication 17, caractérisé par le fait qu'au moins 50% de la cible employée contiennent un alliage ayant l'une des compositions suivantes:

AlCuSn, AlCuPb, AlCuSnPb,

AlSiSn, AlSiPb, AlSiSnPb,

CuSn, CuPb, CuSnPb.

19. Procédé selon les revendications 14 et 15, caractérisé par le fait qu'on applique successivement dans le temps les différents constituants de la couche de glissement.

20 Procédé selon la revendication 19, caractérisé par le fait qu'on applique la couche barrière à la diffusion en utilisant la même cible que la couche de glissement.

21. Procédé selon les revendications 19 et 20, caractérisé par le fait que le composant formant la matrice est appliqué à une température de substrat supérieure à celle pour le composant insoluble dans la matrice.

22. Procédé selon la revendication 21, caractérisé par le fait que le composant formant la matrice est appliqué avant le composant insoluble, et que la température de substrat est abaissée pendant le processus de l'opération de revêtement.

23. Procédé selon les revendications 19 à 22, caractérisé par le fait que les composants ayant les points de fusion plus élevés sont appliqués à des tensions de substrat plus élevées que les composants ayant un point de fusion inférieur.

24. Procédé selon les revendications 14 à 23, caractérisé par le fait que la couche barrière à la diffusion est appliquée à des températures de substrat plus élevées que celles pour les constituants de la couche de glissement.

25. utilisation du matériau composite tel que défini dans les revendications 1 à 13 dans des paliers à glissement.

FIG : 1

EP 0 256 226 B1

(a)

(b)

Fig. 2